(19) Europäisches Patentamt
European Patent Office
Office européen des brevets

(11) **EP 4 772 895 A1**

(12) **EUROPEAN PATENT APPLICATION**
published in accordance with Art. 153(4) EPC

(43) Date of publication:
**08.07.2026 Bulletin 2026/28**

(21) Application number: 25867162.7

(22) Date of filing: **03.09.2025**

(51) International Patent Classification (IPC):
*G01R 31/367* (2019.01)  *G01R 31/36* (2020.01)
*G01R 31/396* (2019.01)  *G01R 31/382* (2019.01)
*H01M 10/44* (2006.01)  *H02J 7/00* (2026.01)

(52) Cooperative Patent Classification (CPC):
**G01R 31/36; G01R 31/367; G01R 31/382;**
**G01R 31/396; H01M 10/44; H02J 7/00;** Y02E 60/10

(86) International application number:
**PCT/KR2025/013619**

(87) International publication number:
**WO 2026/084249 (23.04.2026 Gazette 2026/17)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **14.10.2024 KR 20240139120**

(71) Applicant: **LG ENERGY SOLUTION, LTD.**
**Seoul 07335 (KR)**

(72) Inventors:
• **NOH, Tae Gyun**
**Daejeon, 34122 (KR)**
• **KWAK, Tae Hyun**
**Daejeon, 34122 (KR)**
• **LEE, Eui Kyung**
**Daejeon, 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **METHOD FOR GENERATING RECIPE FOR MULTI STEP CONSTANT CURRENT (MSCC) CHARGING AND METHOD FOR MANUFACTURING SECONDARY BATTERY USING SAME**

(57) According to exemplary embodiments, a method for generating a recipe for MSCC (Multi-Step Constant Current) charging is provided. The method includes: charging a modeling cell to collect charging data of the modeling cell; deriving a current-capacitance model based on the charging data; and generating a recipe for MSCC (Multi-Step Constant Current) charging based on the current-capacitance model.

[FIG. 1]

## Description

[Technical Field]

The present disclosure relates to a method for generating a recipe for MSCC (Multi-Step Constant Current) charging and a method for manufacturing a secondary battery using the same.

This application claims the benefit of Korean Patent Application No. 10-2024-0139120, filed on October 14, 2024, the disclosure of which is incorporated herein by reference.

[Background]

Unlike primary batteries, secondary batteries can be charged and discharged a plurality of times. Secondary batteries are widely used as energy sources for various wireless devices such as handsets, laptops, and wireless vacuum cleaners. Recently, due to improved energy density and economies of scale, the manufacturing cost per unit capacity of secondary batteries has dramatically decreased, and the driving range of BEVs (battery electric vehicles) has increased to a level equivalent to fuel vehicles, thereby shifting the main application of secondary batteries from mobile devices to mobility.

The manufacturing of secondary batteries includes an electrode process including mixing, coating, roll pressing, slitting, and notching processes, an assembly process of embedding an electrode assembly in a case, and an activation process of electrically activating and stabilizing battery cells.

[Summary]

[Technical Problem]

The technical problem to be solved by the technical idea of the present disclosure is to provide a method for generating a recipe for MSCC (Multi-Step Constant Current) charging that can improve the throughput of a method for manufacturing a secondary battery.

[Technical Solution]

According to exemplary embodiments of the present disclosure to solve the above-described problems, a method for generating a recipe for MSCC (Multi-Step Constant Current) charging is provided. The method includes: charging a modeling cell to collect charging data of the modeling cell; deriving a current-capacitance model based on the charging data; and generating a recipe for MSCC (Multi-Step Constant Current) charging based on the current-capacitance model.

The recipe includes the number of steps of the MSCC charging.

The recipe includes the magnitude of current of each of the steps of the MSCC charging.

The current-capacitance model represents the capacitance of an equivalent capacitor of the modeling cell according to the magnitude of current applied to the modeling cell.

Generating the recipe is further based on Equation 1 below.

[Equation 1]

$$\triangle t_{n} = \frac{1}{I_n}\,(V_{MCn} - V_{Rn} - V_n) \times C_b(I_n)$$

Here, $\triangle t_n$ is the duration of the $n^{th}$ step of the MSCC charging, $I_n$ is the magnitude of current of the $n^{th}$ step of the MSCC charging, $V_{MCn}$ is the magnitude of voltage applied to the modeling cell at the completion time of the $n^{th}$ step of the MSCC charging, $V_{Rn}$ is the magnitude of voltage applied to the equivalent resistor of the modeling cell in the $n^{th}$ step of the MSCC charging, $V_n$ is the magnitude of voltage applied to the equivalent capacitor of the modeling cell at the start time of the $n^{th}$ step of the MSCC charging, $C_b(I_n)$ is the capacitance of the equivalent capacitor of the modeling cell determined based on the current-capacitance model when the magnitude of the current of the $n^{th}$ step of the MSCC charging is $I_n$, and n is an integer greater than or equal to 1.

[Equation 2]

$$V_{Rn} = I_n \times R_B$$

Here, $R_B$ is the resistance value of the equivalent resistor of the modeling cell.

$V_n$ satisfies Equation 3 below, wherein

[Equation 3]

$$V_n = V_{MCn\text{-}1} - I_{n\text{-}1} \times R_B$$

Here, $V_{MCn\text{-}1}$ is the voltage applied to the modeling cell at the completion time of the $(n\text{-}1)^{th}$ step of the MSCC charging, and $I_{n\text{-}1}$ is the magnitude of current of the $(n\text{-}1)^{th}$ step of the MSCC charging.

The recipe is determined by SLSQP (Sequential Least Squares Programming).

The SLSQP includes a condition for minimizing the time of the MSCC charging according to the recipe.

The magnitude of current of each of the steps of the MSCC charging of the recipe is greater than the magnitude of current of a subsequent one among the steps of the MSCC charging of the recipe.

A method for manufacturing a secondary battery includes: generating a recipe for MSCC charging;

and charging a plurality of battery cells based on the recipe, wherein the plurality of battery cells is connected in series.

The recipe is generated based on a current-capacitance model, and the current-capacitance model represents the capacitance of an equivalent capacitor of the modeling cell according to current applied to the modeling cell.

The modeling cell is manufactured through the same process as the plurality of battery cells.

The recipe includes the number of steps of the MSCC charging.

The recipe includes the magnitude of current of each of the steps of the MSCC charging.

[Advantageous Effects]

According to exemplary embodiments of the present disclosure, the recipe for MSCC (Multi-Step Constant Current) charging provides the magnitude of current of each of the steps that can minimize the charging speed according to the number of steps of the MSCC charging. Accordingly, by determining the number of steps of the recipe for MSCC charging and the magnitude of current of each of the steps, the throughput of secondary battery manufacturing can be improved.

The effects that may be obtained from the exemplary embodiments of the present disclosure are not limited to those mentioned above, and other effects not mentioned may be clearly derived and understood by one of ordinary skill in the art to which the exemplary embodiments of the present disclosure belong from the following description. That is, unintended effects of practicing the exemplary embodiments of the present disclosure may also be derived from the exemplary embodiments of the present disclosure by one of ordinary skill in the art.

[Brief Description of the Drawings]

FIG. 1 is a flowchart for explaining a method for generating a recipe for MSCC (Multi-Step Constant Current) charging according to exemplary embodiments.
FIG. 2 is a circuit diagram showing charging of a modeling cell.
FIG. 3 shows current and voltage over time of MSCC charging.
FIG. 4 is a capacity-voltage graph of MSCC charging.
FIG. 5 is a capacitance-current graph of MSCC charging.
FIG. 6 is a table showing the magnitude of current of each of the steps according to the number of steps of the recipe for MSCC charging according to exemplary embodiments.
FIG. 7 is a flowchart showing a method for manufacturing a secondary battery according to exemplary embodiments.
FIG. 8 is a block diagram for explaining a secondary battery manufacturing facility 100 according to exemplary embodiments.
FIG. 9 shows a time index generated from a simulation for generating a recipe for MSCC charging according to the number of steps of MSCC charging and the measured time required for MSCC charging.

[Best Mode for Carrying out the Invention]

Hereinafter, preferred embodiments of the present disclosure will be described in detail with reference to the accompanying drawings. It should be noted that the terms and words used in this specification and claims are not to be construed in their ordinary or dictionary sense, but rather in a sense and concept consistent with the technical idea of the disclosure, based on the principle that the inventor may define the concept of a term as he sees fit to best explain his disclosure.

Accordingly, it is to be understood that the embodiments described herein and the configurations shown in the drawings are only the most preferred embodiments of the disclosure and do not represent all of the technical ideas of the disclosure, and that there may be various equivalents and modifications that may be substituted for them at the time of filing the present application.

Furthermore, in describing the disclosure, specific descriptions of relevant disclosed configurations or features are omitted where it is believed that such detailed description would obscure the essence of the disclosure.

Because the embodiments of the present disclosure are provided to more fully illustrate the disclosure to those of ordinary skill in the art, the shapes and sizes of the components in the drawings may be exaggerated, omitted, or shown schematically for clarity. Accordingly, the size or proportion of each component is not necessarily indicative of its actual size or proportion.

(First embodiment)

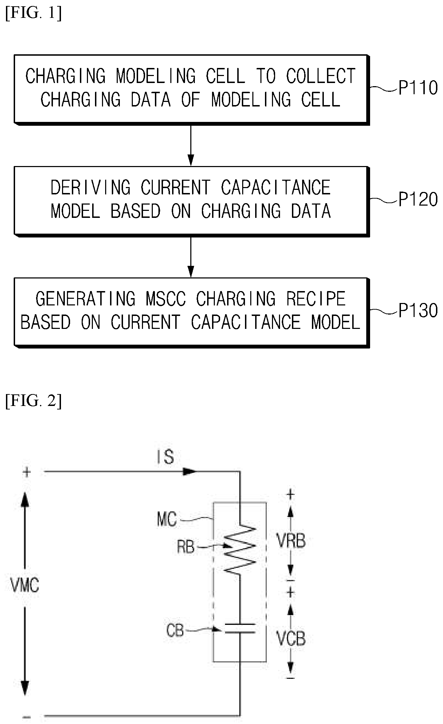

FIG. 1 is a flowchart for explaining a method for generating a recipe for MSCC (Multi-Step Constant Current) charging according to exemplary embodiments.

FIG. 2 is a circuit diagram showing charging of a modeling cell MC.

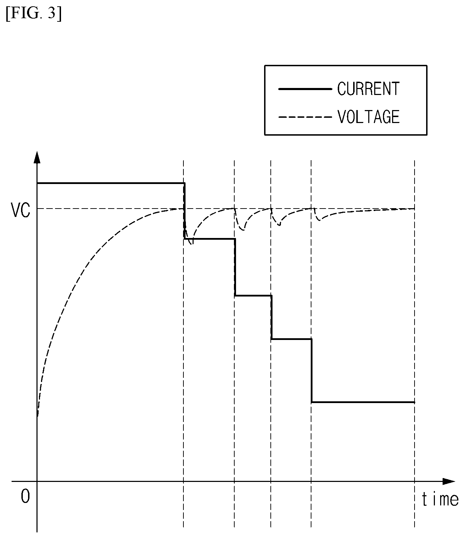

FIG. 3 shows current and voltage over time of MSCC charging.

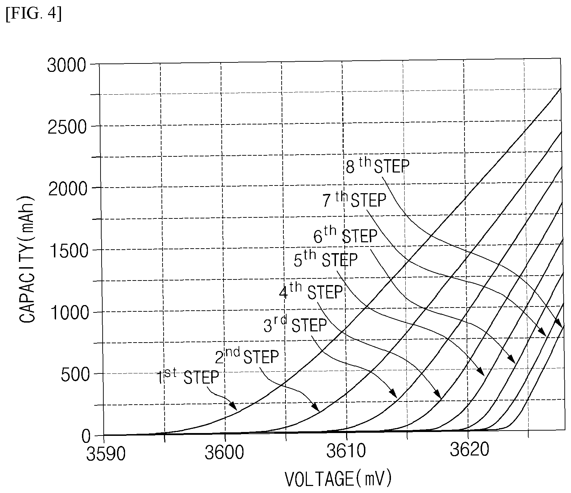

FIG. 4 is a capacity-voltage graph of MSCC charging.

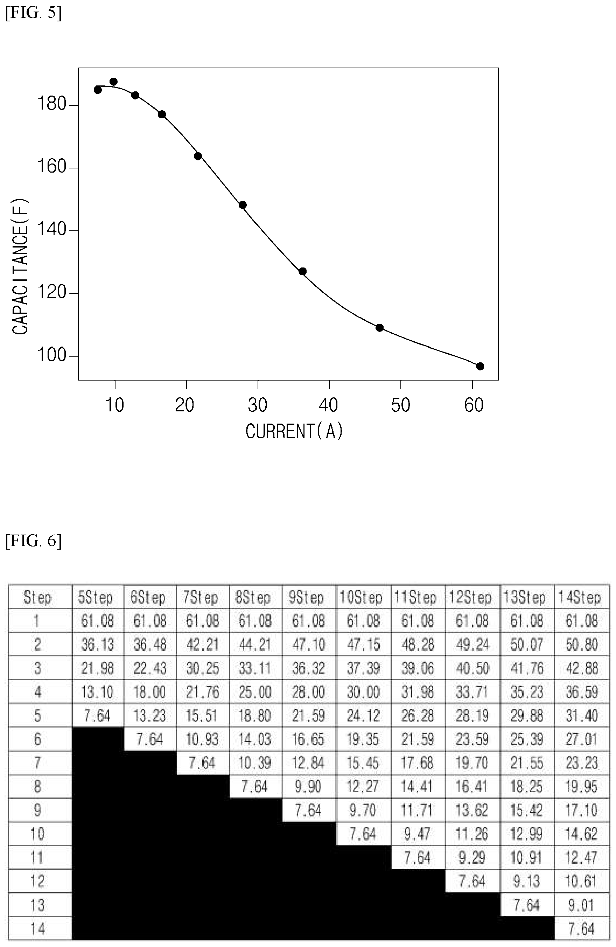

FIG. 5 is a capacitance-current graph of MSCC charging.

FIG. 6 is a table showing the magnitude of current of each of the steps according to the number of steps of the recipe for MSCC charging according to exemplary embodiments.

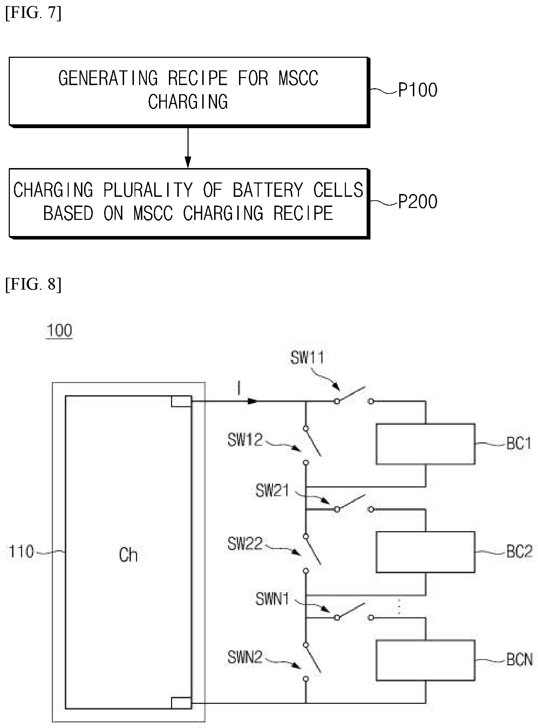

Referring to FIGS. 1 to 3, in P110, a modeling cell MC can be charged to collect charging data of the modeling cell MC. Unlike in FIG. 8 where a plurality of battery cells (BC1, BC2, ..., BCN) are charged at once, the modeling cell MC can be charged singly. That is, the modeling cell MC can be charged in a state in which one modeling cell MC is loaded in a charging facility including a variable current source configured to supply current IS, and charging data including electrical parameters (e.g., voltage, current, and capacity) of the modeling cell MC can be collected while the modeling cell MC is being charged.

The modeling cell MC may include a cell case and an electrode assembly stored in the cell case. The modeling cell MC may further include an electrolyte injected into the cell case, but is not limited thereto. For example, the modeling cell MC may include a solid electrolyte integrated into the electrode assembly.

According to exemplary embodiments, the electrode assembly may include a laminated structure of a plurality of positive electrodes, a plurality of negative electrodes, and a plurality of separators separating the plurality of positive electrodes and the plurality of negative electrodes. According to other exemplary embodiments, the electrode assembly may include a wound structure of a positive electrode, a negative electrode, and a separator. The cell case may include any one of a prismatic metal can, a cylindrical metal can, and a pouch case including a laminated metal (e.g., aluminum) layer.

Each of the plurality of positive electrodes may include a positive electrode current collector and a positive electrode active material. The thickness of the positive electrode current collector may range from about 3 $\mu$m to about 500 $\mu$m. The positive electrode current collector may not cause chemical changes in the finally manufactured secondary battery and may have high conductivity. The positive electrode current collector may include, for example, any one of stainless steel, nickel, titanium, calcined carbon, and aluminum. The positive electrode current collector may include stainless steel surface-treated with carbon, nickel, titanium, silver, or the like. The surface of the positive electrode current collector may include a fine uneven structure to increase adhesion of the active material. The shape of the positive electrode current collector may include any one of film, sheet, foil, net, porous, foam, and nonwoven fabric.

The positive electrode active material is a material capable of causing electrochemical reactions. The positive electrode active material may be a lithium transition metal oxide. The positive electrode active material may include, for example, layered compounds such as lithium cobalt oxide ($LiCoO_2$) and lithium nickel oxide ($LiNiO_2$) substituted with one or more transition metals; lithium manganese oxide substituted with one or more transition metals; lithium nickel-based oxide represented by the formula $LiNi_{1-y}M_yO_2$ (where M is any one of Co, Mn, Al, Cu, Fe, Mg, B, Cr, Zn, and Ga, and $0.01 \leq y \leq 0.7$);

lithium nickel cobalt manganese composite oxide represented by $Li_{1+z}Ni_bMn_cCo_{1-(b+c+d)}M_dO_{(2-e)}A_e$ (where $-0.5 \leq z \leq 0.5$, $0.1 \leq b \leq 0.8$, $0.1 \leq c \leq 0.8$, $0 \leq d \leq 0.2$, $0 \leq e \leq 0.2$, $b+c+d<1$, M is any one of Al, Mg, Cr, Ti, Si, and Y, and A is any one of F, P, and Cl), such as $Li_{1+z}Ni_{1/3}Co_{1/3}Mn_{1/3}O_2$, $Li_{1+z}Ni_{0.4}Mn_{0.4}Co_{0.2}O_2$; and olivine-based lithium metal phosphate represented by the formula $Li_{1+x}M_{1-y}M'_yPO_{4-z}X_z$ (where M is a transition metal, more specifically any one of Fe, Mn, Co, and Ni, M' is any one of Al, Mg, and Ti, X is any one of F, S, and N, $-0.5 \leq x \leq +0.5$, $0 \leq y \leq 0.5$, and $0 \leq z \leq 0.1$).

Each of the plurality of negative electrodes EN may include a negative electrode current collector and a negative electrode active material. The thickness of the negative electrode current collector may range from about 3 $\mu$m to about 500 $\mu$m. The negative electrode current collector may not cause chemical changes in the finally manufactured secondary battery and may have high conductivity. The negative electrode current collector may include any one of copper, stainless steel, aluminum, nickel, titanium, calcined carbon, and aluminum-cadmium alloy. The negative electrode current collector may include stainless steel surface-treated with carbon, nickel, titanium, silver, or the like. The surface of the negative electrode current collector may include a fine uneven structure to increase adhesion of the active material. The shape of the negative electrode current collector may include any one of film, sheet, foil, net, porous, foam, and nonwoven fabric.

The negative electrode active material may include, for example, carbon such as non-graphitizable carbon and graphite-based carbon. The negative electrode active material may include, for example, metal composite oxides such as $Li_xFe_2O_3(0 \leq x \leq 1)$, $LixWO_2$ ($0 \leq x \leq 1$), $Sn_xMe_{1-x}Me'_yO_z$ (where Me is any one of Mn, Fe, Pb, and Ge, Me' is any one of Al, B, P, Si, Group 1, 2, 3 elements of the periodic table, and halogens; $0<x \leq 1$, $1 \leq y \leq 3$, and $1 \leq z \leq 8$). The negative electrode active material may include, for example, any one of lithium metal; lithium alloy; silicon-based alloy; and tin-based alloy. The negative electrode active material may include, for example, metal oxides such as $SnO$, $SnO_2$, $PbO$, $PbO_2$, $Pb_2O_3$, $Pb_3O_4$, $Sb_2O_3$, $Sb_2O_4$, $Sb_2O_5$, $GeO$, $GeO_2$, $Bi_2O_3$, $Bi_2O_4$, and $Bi_2O_5$. The negative electrode active material may include, for example, conductive polymers such as polyacetylene; Li-Co-Ni-based materials, etc.

The electrolyte may be any one of a non-aqueous electrolyte, an aqueous electrolyte, an ionic electrolyte, and a gel electrolyte. The electrolyte may be a solid electrolyte. The non-aqueous electrolyte may include an organic solvent such as ethylene carbonate and dimethyl carbonate and a lithium salt such as $LiPF_6$ and $LiBF_4$ dissolved in the organic solvent. The non-aqueous electrolyte may include ethylene carbonate dissolved in tetraethylammonium salts. The aqueous electrolyte may include a sodium chloride solution, a sulfuric acid solution, a hydrochloric acid solution, and a sodium hydroxide solution. The ionic electrolyte is an ionic compound that is in a liquid state at room temperature, such as ethylmethylimidazolium bis(trifluoromethylsulfonyl)amide, and has high thermal stability. The gel electrolyte may be provided by using a liquid electrolyte with polyacrylonitrile and PVA. The solid electrolyte may include a polymer material doped with lithium salt (e.g., polyethylene oxide (PEO)) and a ceramic electrolyte composed of ceramic materials such as NASICON and LLZO.

The modeling cell MC can be modeled as an equivalent resistor RB and an equivalent capacitor CB. The modeling cell MC can be charged in an MSCC charging method, but is not limited thereto. In general, the magnitude of the current IS of a preceding step of MSCC charging may be greater than the magnitude of the current IS of a subsequent step. For example, as shown in the graph of FIG. 3, the magnitude of the current IS of the first step may be greater than the magnitude of the current IS of the second step, the magnitude of the current IS of the second step may be greater than the magnitude of the current IS of the third step, the magnitude of the current IS of the third step may be greater than the magnitude of the current IS of the fourth step, and the magnitude of the current IS of the fourth step may be greater than the magnitude of the current IS of the fifth step.

The voltage VMC applied to the modeling cell MC is the sum of the voltage VRB applied to the equivalent resistor RB and the voltage VCB applied to the equivalent capacitor CB. Accordingly, the voltage VCB applied to the equivalent capacitor CB is equal to the difference between the voltage VMC applied to the modeling cell MC and the voltage VRB applied to the equivalent resistor RB.

In each of the steps of the recipe for MSCC charging, the modeling cell MC is charged up to the charging voltage VC, and the voltage VRB applied to the equivalent resistor RB is proportional to the current. When the magnitude of the current IS decreases as the previous step transitions to the subsequent step, the voltage VRB applied to the equivalent resistor RB decreases, so the voltage VMC applied to both ends of the modeling cell MC also decreases. As the equivalent capacitor CB is charged by the current IS, the voltage VMC applied to the modeling cell MC rises again to the charging voltage VC.

Charging the modeling cell MC is to store a target capacity in the equivalent capacitor CB of each modeling cell MC, which is the same as charging the equivalent capacitor CB with current IS so that the voltage VCB applied to the equivalent capacitor CB becomes the target voltage.

When each modeling cell MC is charged up to the charging voltage VC with a sufficiently low current IS in the last step of the MSCC, the equivalent capacitor CB of each modeling cell MC can be charged to the target capacity.

Next, referring to FIGS. 1, 2, 4, and 5, in P120, a current-capacitance model can be derived based on the charging data.

As shown in FIG. 4, in the first to eighth steps of MSCC charging, it was confirmed that the slope of the capacity-voltage curve is at least partially constant. Since the slope of the capacity-voltage curve is the same as the capacitance of the equivalent capacitor CB of each modeling cell MC, even when modeling the capacitance of the equivalent capacitor CB of the modeling cell MC as the magnitude of the current IS, sufficient consistency with the capacitance of the equivalent capacitor CB of the modeling cell MC can be secured. Based on what is described herein, those skilled in the art will be able to easily arrive at an embodiment of modeling the capacitance of the equivalent capacitor CB of the modeling cell MC with multiple variables including the magnitude of the voltage VMC applied to the modeling cell MC and the magnitude of the current IS based on the charging data of the modeling cell MC.

According to exemplary embodiments, from the charging data of the modeling cell MC, a current-capacitance model representing the capacitance of the equivalent capacitor CB of the modeling cell MC according to the current IS can be derived. The derivation of the current-capacitance model may be based on data modeling of the capacitance of the equivalent capacitor CB of each modeling cell MC and the magnitude of the current IS applied to the modeling cell MC in the charging data. Such data modeling may use methodologies of regression analysis such as linear regression analysis, polynomial regression analysis, logistic regression analysis, and multiple regression analysis, but is not limited thereto. FIG. 5 is a graph showing the current-capacitance model derived in P120.

At this time, for deriving the current-capacitance model, collecting charging data of the modeling cell MC in P110 may be repeatedly performed for a plurality of different modeling cells MC, and accordingly, deriving the current-capacitance model in P120 may be based on charging data collected from the plurality of modeling cells MC.

Next, referring to FIGS. 1 and 5, in P130, a recipe for MSCC charging can be generated based on the current-capacitance model. Generating the recipe for MSCC charging may include determining the number of steps of the recipe for MSCC charging and the magnitude of current of each of the steps that satisfy the minimum charging time condition based on Equation 1 below. Accordingly, the recipe for MSCC charging includes the number of steps of MSCC charging and the magnitude of current of each of the steps of MSCC charging.

[Equation 1]

$$\triangle t_{n=}\frac{1}{I_n}(V_{MCn}-V_{Rn}-V_n)\times C_b(I_n)$$

Here, $\Delta t_n$ is the duration of the $n^{th}$ step of the MSCC charging, $I_n$ is the magnitude of current IS of the $n^{th}$ step of the MSCC charging, $V_{MCn}$ is the magnitude of voltage VMC applied to the modeling cell MC at the completion time of the $n^{th}$ step of the MSCC charging, $V_{Rn}$ is the magnitude of voltage VRB applied to the equivalent resistor RB of the modeling cell MC in the $n^{th}$ step of the MSCC charging, Vn is the magnitude of voltage applied to the equivalent capacitor of the modeling cell at the start time of the nth step of the MSCC charging, $C_b(I_n)$ is the capacitance of the equivalent capacitor CB determined based on the current-capacitance model when the magnitude of the current IS of the $n^{th}$ step of the MSCC charging is $I_n$. n is an integer greater than or equal to 1.

$V_{Rn}$ satisfies Equation 2 below.

[Equation 2]

$$V_{Rn} = I_n \times R_B$$

Here, $R_B$ is the resistance value of the equivalent resistor of the modeling cell.

. $V_n$ satisfies Equation 3 below.

[Equation 3]

$$V_n = V_{MCn-1} - I_{n-1} \times R_B$$

Here, $V_{MCn-1}$ is the voltage applied to the modeling cell MC at the completion time of the $(n-1)^{th}$ step of the MSCC charging, and $I_{n-1}$ is the magnitude of current IS of the $(n-1)^{th}$ step of the MSCC charging. When n=1, $I_0$ is typically 0, and $V_{MC0}$ can be 0 or have a non-zero initial voltage.

The recipe for MSCC charging may be determined, for example, by an optimization methodology. An example of the optimization methodology is SLSQP (Sequential Least Squares Programming). SLSQP is an optimization algorithm used to solve nonlinear programming problems with equality and inequality constraints. SLSQP works by linearizing the objective function and constraints at each iteration and then solving this linearized problem. This method uses a quasi-Newton approach that approximates the Hessian of the Lagrangian to improve the convergence rate. SLSQP is available through the optimize module of Python's SciPy library as shown in the code below:

```
res = minimize(func, x0, method='SLSQP',
bounds=bnds, constraints=cons)
print('Optimal solution:', res.x)
print('Minimum value:', res.fun)
Optimal solution: [61.08 50.79856993 42.87768134
36.58998626    31.40140849    27.00740182
23.22887954    19.9528082    17.10314354
14.62432914    12.4728853    10.61208643
9.00915843 7.634]
Minimum value: 356.1335555839794
```

Func is the charging time that is the object to be minimized, $x_0$ includes the condition for the magnitude of the current IS of the first step, Bnds is the constraint condition for the range of current, and CONSTRAINTS is the boundary condition for simulation. The boundary condition is that in each step of MSCC charging, the magnitude of the current IS of the subsequent step is smaller than the magnitude of the current IS of the preceding step.

Optimal solution represents the magnitude of current of each of the 14 steps when MSCC charging includes 14 steps. Minimum value is an index in arbitrary units representing the charging time. The index is not the actual measured time, but has a value proportional to the time required according to the simulation.

FIG. 6 shows the current of each of the steps of the recipe for MSCC charging that satisfies the minimum charging time condition for 10 cases where MSCC charging includes 5 to 14 steps. The unit of current is mA.

(Second embodiment)

FIG. 7 is a flowchart for explaining a method for manufacturing a secondary battery according to exemplary embodiments.

FIG. 8 is a block diagram for explaining a secondary battery manufacturing facility 100 according to exemplary embodiments.

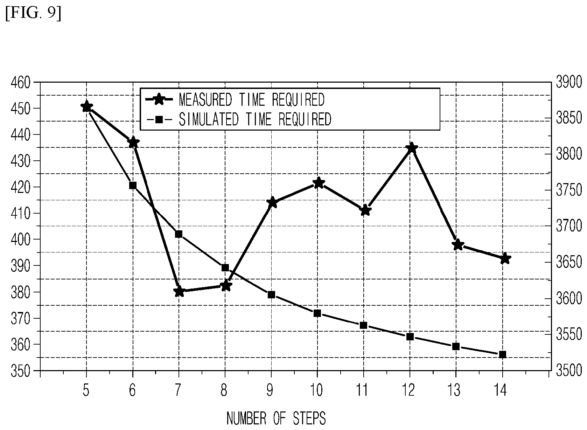

FIG. 9 shows the measured time required for MSCC charging of a recipe that includes 5 to 14 steps and satisfies the minimum charging time condition of MSCC.

Referring to FIGS. 7 and 8, in P100, a recipe for MSCC charging can be generated. The recipe for MSCC charging can be provided in substantially the same manner as described with reference to P110 to P130 of FIG. 1.

Next, referring to FIGS. 7 and 9, a plurality of battery cells (BC1, BC2, ..., BCN) can be charged based on the recipe for MSCC charging. The plurality of battery cells (BC1, BC2, ..., BCN) can be charged by the secondary battery manufacturing facility 100.

The plurality of battery cells (BC1, BC2, ..., BCN) can be manufactured through substantially the same process as the plurality of modeling cells (MC, see FIG. 2). The plurality of battery cells (BC1, BC2, ..., BCN) may have similar specifications to the plurality of modeling cells (MC, see FIG. 2). Accordingly, the current-capacitance model derived from the charging data for the plurality of modeling cells (MC, see FIG. 2) may also be valid for the plurality of battery cells (BC1, BC2, ..., BCN), and the recipe for MSCC charging generated based on the current-capacitance model of the plurality of modeling cells (MC, see FIG. 2) may also satisfy the minimum charging time condition for the plurality of battery cells (BC1, BC2, ..., BCN).

Unlike in FIG. 2 where charging data of the individually charged modeling cell MC is collected, the plurality of battery cells (BC1, BC2, ..., BCN) can be charged at least partially simultaneously. The secondary battery manufacturing facility 100 may include a variable current source 110 for charging the plurality of battery cells (BC1, BC2, ..., BCN) at least partially simultaneously, and a plurality of switching elements (SW11, SW12, SW21, SW22, ..., SWN1, SWN2) configured to connect the plurality of battery cells (BC1, BC2, ..., BCN) in series and provide an electrical path to bypass some of the plurality of battery cells (BC1, BC2, ..., BCN).

For example, the switching element SW11 can provide an electrical path for charging the battery cell BC1 or block the electrical path for charging the battery cell BC1. The switching element SW12 can provide a path for bypassing the battery cell BC1 when the battery cell BC1 is fully charged before some of the battery cells (BC2, ..., BCN) in a specific step of the recipe for MSCC charging.

More specifically, when a specific step of the recipe for MSCC charging starts, the switching elements (SW11, SW21, ..., SWN1) may be in an on state, and the switching elements (SW12, SW22, ..., SWN2) may be in an off state. Accordingly, the plurality of battery cells (BC1, BC2, ..., BCN) connected in series can be charged by the variable current source 110.

Due to production tolerances (i.e., allowable errors) and charging environment tolerances, not all of the plurality of battery cells (BC1, BC2, ..., BCN) have the same characteristics. Accordingly, some of the plurality of battery cells (BC1, BC2, ..., BCN) are charged first, and other some of the plurality of battery cells (BC1, BC2, ..., BCN) are charged later.

For example, when the battery cell BC1 is charged first, the switching element SW11 is switched from an on state to an off state, and the switching element SW12 is switched from an off state to an on state, so that the charging of the battery cell BC1 can be terminated and a bypass path including the switching element SW12 can be provided. Accordingly, each of the battery cells (BC2, ..., BCN) can be charged until it reaches the charging voltage in a specific step of MSCC charging. The above-described operation of the plurality of switching elements (SW11, SW12, SW21, SW22, ..., SWN1, SWN2) can be repeated in a similar manner until all of the plurality of battery cells (BC1, BC2, ..., BCN) are charged. After all of the plurality of battery cells (BC1, BC2, ..., BCN) reach the charging voltage in a specific step of MSCC charging, the current of the next step of MSCC charging can be applied.

Due to various delays including these switching operations, when the number of steps of MSCC charging increases, additional delay time is required. Referring to FIG. 9, it was confirmed that as the number of steps increases, the time index due to charging itself decreases. At this time, due to the accumulation of additional delay time due to the increase in the number of steps, it was confirmed that the time required for MSCC charging is shortest when MSCC charging includes 7 to 8 steps.

According to exemplary embodiments, a recipe for MSCC charging with a minimum charging time condition can be generated, which allows MSCC-based series charging as described below. In general, since the voltage of each battery cell is at a level of several volts, energy loss due to step-down of commercial voltage is large during MSCV (Multi-Stage Constant Voltage) charging. According to exemplary embodiments, by performing MSCC charging by connecting a plurality of battery cells in series, transformation is unnecessary, so energy loss due to transformation can be prevented. Furthermore, since a plurality of battery cells connected in series are charged based on a recipe for MSCC charging that satisfies the minimum charging time condition, the throughput of secondary battery manufacturing can be improved.

Furthermore, the recipe for MSCC steps can be determined based on additional constraint conditions such as the current magnitude of the first step according to the quality of the CEI (Cathode Electrolyte Interphase) layer and SEI (Solid Electrolyte Interphase) layer, the charging time at a specific voltage level for energy expression of a specific active material, etc.

The present disclosure has been described in more detail above with reference to the drawings and embodiments. However, it is to be understood that the configurations shown in the drawings or embodiments described herein are only one embodiment of the disclosure and do not represent all of the technical ideas of the disclosure, and that there may be various equivalents and modifications that may be substituted for them at the time of filing the present application.

**Claims**

1. A method for generating a recipe for MSCC charging, comprising:

    charging a modeling cell to collect charging data of the modeling cell;
    deriving a current-capacitance model based on the charging data; and
    generating a recipe for MSCC (Multi-Step Constant Current) charging based on the current-capacitance model.

2. The method for generating a recipe for MSCC charging of claim 1, wherein
the recipe comprises the number of steps of the MSCC charging.

3. The method for generating a recipe for MSCC charging of claim 2, wherein

the recipe comprises the magnitude of current of each of the steps of the MSCC charging.

4. The method for generating a recipe for MSCC charging of claim 1, wherein
the current-capacitance model represents the capacitance of an equivalent capacitor of the modeling cell according to the magnitude of current applied to the modeling cell.

5. The method for generating a recipe for MSCC charging of claim 1, wherein

generating the recipe is further based on Equation 1 below, wherein

[Equation 1]

$$\triangle t_{n} = \frac{1}{I_n}\left(V_{MCn} - V_{Rn} - V_n\right) \times C_b(I_n)$$

Here, $\Delta t_n$ is the duration of the $n^{th}$ step of the MSCC charging, $I_n$ is the magnitude of current of the $n^{th}$ step of the MSCC charging, $V_{MCn}$ is the magnitude of voltage applied to the modeling cell at the completion time of the $n^{th}$ step of the MSCC charging, $V_{Rn}$ is the magnitude of voltage applied to the equivalent resistor of the modeling cell in the $n^{th}$ step of the MSCC charging, $V_n$ is the magnitude of voltage applied to the equivalent capacitor of the modeling cell at the start time of the $n^{th}$ step of the MSCC charging, $C_b(I_n)$ is the capacitance of the equivalent capacitor of the modeling cell determined based on the current-capacitance model when the magnitude of the current of the $n^{th}$ step of the MSCC charging is $I_n$, and n is an integer greater than or equal to 1.

6. The method for generating a recipe for MSCC charging of claim 5, wherein

$V_{Rn}$ satisfies Equation 2 below, wherein

[Equation 2]

$$V_{Rn} = I_n \times R_B$$

Here, $R_B$ is the resistance value of the equivalent resistor of the modeling cell.

7. The method for generating a recipe for MSCC charging of claim 6, wherein

$V_n$ satisfies Equation 3 below, wherein

[Equation 3]

$$V_n = V_{MCn-1} - I_{n-1} \times R_B$$

Here, $V_{MCn-1}$ is the voltage applied to the modeling cell at the completion time of the $(n-1)^{th}$ step of the MSCC charging, and $I_{n-1}$ is the magnitude of current of the $(n-1)^{th}$ step of the MSCC charging.

8. The method for generating a recipe for MSCC charging of claim 7, wherein
the recipe is determined by SLSQP (Sequential Least Squares Programming).

9. The method for generating a recipe for MSCC charging of claim 8, wherein
the SLSQP comprises a condition for minimizing the time of the MSCC charging according to the recipe.

10. The method for generating a recipe for MSCC charging of claim 8, wherein
the magnitude of current of each of the steps of the MSCC charging of the recipe is greater than the magnitude of current of a subsequent one among the steps of the MSCC charging of the recipe.

11. A method for manufacturing a secondary battery, comprising:

generating a recipe for MSCC charging; and
charging a plurality of battery cells based on the recipe, wherein
the plurality of battery cells is connected in series.

12. The method for manufacturing a secondary battery of claim 11, wherein

the recipe is generated based on a current-capacitance model, and
the current-capacitance model represents the capacitance of an equivalent capacitor of the modeling cell according to current applied to the modeling cell.

13. The method for manufacturing a secondary battery of claim 12, wherein
the modeling cell is manufactured through the same process as the plurality of battery cells.

14. The method for manufacturing a secondary battery of claim 11, wherein
the recipe comprises the number of steps of the MSCC charging.

15. The method for manufacturing a secondary battery of claim 12, wherein
the recipe comprises the magnitude of current of each of the steps of the MSCC charging.

[FIG. 1]

```
┌─────────────────────────────────────┐
│  CHARGING MODELING CELL TO COLLECT   │ ～P110
│  CHARGING DATA OF MODELING CELL      │
└─────────────────────────────────────┘
                  │
                  ▼
┌─────────────────────────────────────┐
│   DERIVING CURRENT CAPACITANCE       │ ～P120
│   MODEL BASED ON CHARGING DATA       │
└─────────────────────────────────────┘
                  │
                  ▼
┌─────────────────────────────────────┐
│  GENERATING MSCC CHARGING RECIPE     │ ～P130
│  BASED ON CURRENT CAPACITANCE MODEL  │
└─────────────────────────────────────┘
```

[FIG. 2]

[FIG. 3]

[FIG. 4]

[FIG. 5]

[FIG. 6]

| Step | 5Step | 6Step | 7Step | 8Step | 9Step | 10Step | 11Step | 12Step | 13Step | 14Step |
|---|---|---|---|---|---|---|---|---|---|---|
| 1 | 61.08 | 61.08 | 61.08 | 61.08 | 61.08 | 61.08 | 61.08 | 61.08 | 61.08 | 61.08 |
| 2 | 36.13 | 36.48 | 42.21 | 44.21 | 47.10 | 47.15 | 48.28 | 49.24 | 50.07 | 50.80 |
| 3 | 21.98 | 22.43 | 30.25 | 33.11 | 36.32 | 37.39 | 39.06 | 40.50 | 41.76 | 42.88 |
| 4 | 13.10 | 18.00 | 21.76 | 25.00 | 28.00 | 30.00 | 31.98 | 33.71 | 35.23 | 36.59 |
| 5 | 7.64 | 13.23 | 15.51 | 18.80 | 21.59 | 24.12 | 26.28 | 28.19 | 29.88 | 31.40 |
| 6 | | 7.64 | 10.93 | 14.03 | 16.65 | 19.35 | 21.59 | 23.59 | 25.39 | 27.01 |
| 7 | | | 7.64 | 10.39 | 12.84 | 15.45 | 17.68 | 19.70 | 21.55 | 23.23 |
| 8 | | | | 7.64 | 9.90 | 12.27 | 14.41 | 16.41 | 18.25 | 19.95 |
| 9 | | | | | 7.64 | 9.70 | 11.71 | 13.62 | 15.42 | 17.10 |
| 10 | | | | | | 7.64 | 9.47 | 11.26 | 12.99 | 14.62 |
| 11 | | | | | | | 7.64 | 9.29 | 10.91 | 12.47 |
| 12 | | | | | | | | 7.64 | 9.13 | 10.61 |
| 13 | | | | | | | | | 7.64 | 9.01 |
| 14 | | | | | | | | | | 7.64 |

[FIG. 7]

GENERATING RECIPE FOR MSCC CHARGING — P100

CHARGING PLURALITY OF BATTERY CELLS BASED ON MSCC CHARGING RECIPE — P200

[FIG. 8]

[FIG. 9]

## INTERNATIONAL SEARCH REPORT

| | International application No. |
|---|---|
| | **PCT/KR2025/013619** |

### A. CLASSIFICATION OF SUBJECT MATTER

**G01R 31/367**(2019.01)i; **G01R 31/36**(2006.01)i; **G01R 31/396**(2019.01)i; **G01R 31/382**(2019.01)i; **H01M 10/44**(2006.01)i; **H02J 7/00**(2006.01)i

According to International Patent Classification (IPC) or to both national classification and IPC

### B. FIELDS SEARCHED

Minimum documentation searched (classification system followed by classification symbols)

G01R 31/367(2019.01); G01R 19/00(2006.01); G01R 31/36(2006.01); G01R 31/392(2019.01); H01M 10/44(2006.01); H02J 7/00(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (MOIP internal) & keywords: 충전(charge), 모델(model), 전류(current), 커패시턴스(capacitance), 직렬(serial), 레시피(recipe)

### C. DOCUMENTS CONSIDERED TO BE RELEVANT

| Category* | Citation of document, with indication, where appropriate, of the relevant passages | Relevant to claim No. |
|---|---|---|
| X | KR 10-2094359 B1 (KYUNGPOOK NATIONAL UNIVERSITY INDUSTRY-ACADEMIC COOPERATION FOUNDATION) 27 March 2020 (2020-03-27) paragraphs [0032]-[0131], claim 8 and figures 1-8 | 1-10 |
| Y | | 11-15 |
| Y | KR 10-2023-0152210 A (PUSAN UNIVERSITY OF FOREIGN STUDIES et al.) 03 November 2023 (2023-11-03) paragraphs [0015]-[0061] and figures 2-5 | 11-15 |
| A | KR 10-2022-0070480 A (BENNING CMS TECHNOLOGY GMBH) 31 May 2022 (2022-05-31) paragraphs [0053]-[0162] and figures 1-10 | 1-15 |
| A | JP 2020-009724 A (TOYOTA MOTOR CORP.) 16 January 2020 (2020-01-16) paragraphs [0017]-[0073] and figures 1-7 | 1-15 |

☑ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **05 December 2025** | **05 December 2025** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**EP 4 772 895 A1**

**INTERNATIONAL SEARCH REPORT**

| International application No. |
|---|
| **PCT/KR2025/013619** |

**C. DOCUMENTS CONSIDERED TO BE RELEVANT**

| Category* | Citation of document, with indication, where appropriate, of the relevant passages | Relevant to claim No. |
|---|---|---|
| A | US 2024-0162736 A1 (UNIVERSITE LIBRE DE BRUXELLES) 16 May 2024 (2024-05-16) paragraphs [0051]-[0153] and figures 1-5 | 1-15 |

Form PCT/ISA/210 (second sheet) (July 2022)

**INTERNATIONAL SEARCH REPORT**
Information on patent family members

International application No.

**PCT/KR2025/013619**

| Patent document cited in search report | | | Publication date (day/month/year) | Patent family member(s) | | | Publication date (day/month/year) |
|---|---|---|---|---|---|---|---|
| KR | 10-2094359 | B1 | 27 March 2020 | KR | 10-2148204 | B1 | 26 August 2020 |
| | | | | WO | 2021-118170 | A1 | 17 June 2021 |
| KR | 10-2023-0152210 | A | 03 November 2023 | KR | 10-2689216 | B1 | 30 July 2024 |
| KR | 10-2022-0070480 | A | 31 May 2022 | AU | 2020-367926 | A1 | 12 May 2022 |
| | | | | AU | 2020-367926 | B2 | 14 September 2023 |
| | | | | CA | 3154716 | A1 | 22 April 2021 |
| | | | | CN | 114585936 | A | 03 June 2022 |
| | | | | CN | 114585936 | B | 23 September 2025 |
| | | | | DE | 102019127828 | A1 | 15 April 2021 |
| | | | | DE | 102019127828 | B4 | 20 May 2021 |
| | | | | DE | 112020004986 | A5 | 30 June 2022 |
| | | | | EP | 4045925 | A2 | 24 August 2022 |
| | | | | EP | 4045925 | B1 | 07 May 2025 |
| | | | | JP | 2022-552957 | A | 21 December 2022 |
| | | | | JP | 7394983 | B2 | 08 December 2023 |
| | | | | US | 12372581 | B2 | 29 July 2025 |
| | | | | US | 2024-0295605 | A1 | 05 September 2024 |
| | | | | WO | 2021-073690 | A2 | 22 April 2021 |
| | | | | WO | 2021-073690 | A3 | 10 June 2021 |
| JP | 2020-009724 | A | 16 January 2020 | BR | 102019013892 | A2 | 21 January 2020 |
| | | | | CN | 110718721 | A | 21 January 2020 |
| | | | | CN | 110718721 | B | 12 August 2022 |
| | | | | EP | 3595055 | A1 | 15 January 2020 |
| | | | | EP | 3595055 | B1 | 21 September 2022 |
| | | | | JP | 6965839 | B2 | 10 November 2021 |
| | | | | KR | 10-2020-0007668 | A | 22 January 2020 |
| | | | | KR | 10-2154143 | B1 | 09 September 2020 |
| | | | | RU | 2708886 | C1 | 12 December 2019 |
| | | | | US | 11271257 | B2 | 08 March 2022 |
| | | | | US | 2020-0020989 | A1 | 16 January 2020 |
| US | 2024-0162736 | A1 | 16 May 2024 | CN | 117751296 | A | 22 March 2024 |
| | | | | EP | 4057017 | A1 | 14 September 2022 |
| | | | | JP | 2024-510195 | A | 06 March 2024 |
| | | | | KR | 10-2023-0175191 | A | 29 December 2023 |
| | | | | WO | 2022-189454 | A1 | 15 September 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240139120